# EUROPEAN PATENT APPLICATION

(11) **EP 2 680 546 A1**
(43) Date of publication of application: **01.01.2014**
(21) Application number: 12749419.3
(22) Date of filing: 22.02.2012
(51) Int. Cl.: H04M 1/02, H05K 5/02

(54) **INFORMATION TERMINAL**

(30) Priority: 23.02.2011 JP 2011036621
(71) Applicant: NEC CASIO Mobile Communications, Ltd., Kawasaki-shi Kanagawa 211-8666 (JP); NTT DOCOMO, INC., Chiyoda-ku Tokyo 100-6150 (JP)
(72) Inventor: SATO, Junya, Kawasaki-shi, Kanagawa 211-8666 (JP); KOMIYAMA, Takehiko, Kawasaki-shi, Kanagawa 211-8666 (JP); HOMMA, Yasuyuki, Kakegawa-shi, Shizuoka 436-8501 (JP); YANO, Eiji, Tokyo 100-6150 (JP); NAGATA, Ryuuji, Tokyo 100-6150 (JP); SUGISAKI, Haruhiko, Tokyo 100-6150 (JP)
(74) Representative: Vossius & Partner
(86) International application number: PCT/JP2012/054321
(87) International publication number: WO 2012/115168

(57) **Abstract**

A casing structure is provided which is optimum in assembling and maintenance performance and which is less likely to become disengaged and detached on falling down. An information terminal includes: a front side casing member including in turn a section for clamping on each of two opposite top and bottom sides or on each of two opposite left and right sides of the information terminal when seen from a front side of the terminal, the sections for clamping extending along directions of the opposite sides; a back side casing member including another section for clamping corresponding to the section for clamping of a front side casing member, the back side casing member accommodating an inner structure of the information terminal in conjunction with the front side casing member; a pair of frame members, each frame member holding the section for clamping of the front side casing member and the other section for clamping of the back side casing member together in a clamped state; a first lock mechanism that, after thrusting the frame members onto the section for clamping and the other section for clamping, performs locking when the frame members are slid in a direction along the opposite sides; and a second lock mechanism that suppresses movement of the frame members following the locking.

## Description

### TECHNICAL FIELD

### (DESCRIPTION OF RELATED APPLICATION)

The present application is based on and claims the benefit of the priority of JP Patent Application No. 2011-036621 filed in Japan on February 23, 2011, whose entire disclosure is to be incorporated herein by reference thereto.

This invention relates to an information terminal and, more particularly, to a casing structure therefor.

### BACKGROUND

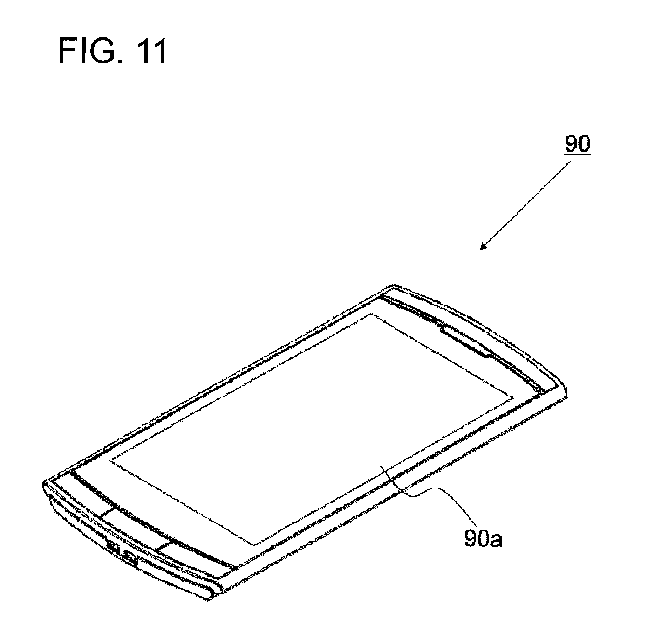

The information terminals with a larger display area, such as smartphones or tablet terminals, are now being used in increasing numbers. An information terminal 90 is featured by a large display area 90a to improve its user friendliness, as shown in Fig.11. These days, the information terminal 90 per se is becoming thinner in thickness to improve its portability.

However, as the display area 90a becomes larger in size, and the information terminal 90 is thinner in thickness, the risk becomes high that its display part 90a, formed mainly of glass, becomes cracked, or that the information terminal 90 per se becomes deformed. It is thus there is a need to provide for a sufficient strength of the information terminal as an apparatus.

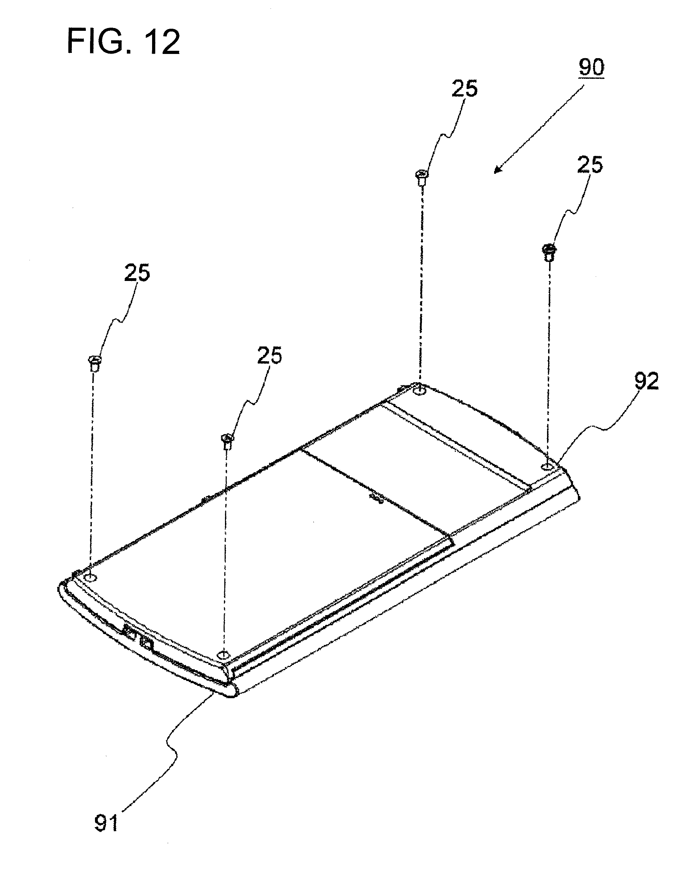

Moreover, in the above described information terminal 90, to evade the risk that the casing becomes disengaged and opened on falling down, it is taken to be necessary to use set screws 25 at least at the four corners for fitting and securing a front side casing member 91 and a rear side casing member 92 together, as shown in Fig.12. If the information terminal is to be reduced further in size and thickness, the very presence of the four screw boss sections, needed for mounting the set screws 25, is deterrent to securing a packaging space for the information terminal 90.

Patent Literature 1 discloses a configuration of a mobile electronic apparatus, such as mobile phone, PDA (Personal Digital Assistant) or game machine, in which a front casing and a rear casing are fixed together by a channel shaped clamp section called a side part.

Patent Literature 2 discloses a configuration in which, to reduce the number of set screws, upper and lower covers are fixed together by a clip having a channel shaped cross-section.

### CITATION LIST

### PATENT LITERATURE

[Patent Literature 1]
   JP Patent Kokai Publication No. JP2010-81570A
[Patent Literature 2]
   JP Patent Kokai Publication No. JP2002-207985A

### SUMMARY

### TECHNICAL PROBLEM

The disclosures of the above mentioned Patent Literatures are to be incorporated herein by reference.

The following analysis is given by the present invention.

In the case of the side part of Patent Literature 1, the side part has to be slid a longer distance in mounting. Hence, if it is applied to an information terminal of a thin thickness, the main body part of the information terminal may be damaged at the time of assembling, or the assembling performance may be deteriorated.

In the case of a cover structure of Patent Literature 2, there is a risk that the clip may be disengaged at the time of falling down so that the upper and lower covers are also disengaged. To prevent such disengagement, the Patent Literature shows a configuration in which a protuberance formed at the foremost part of the clip is inserted and secured in engagement insertion opening parts of the upper and lower covers, and a configuration in which the clip and the covers are bonded together by a double-sided adhesive tape. However, these configurations suffer a problem that the mounting performance as well as the maintenance performance is seriously deteriorated.

In light of the above mentioned status of the prior art, it is an object of the present invention to provide an information terminal having a casing structure in which the assembling performance as well as the maintenance performance may be secured and in which there is but little risk of disengagement at the time of falling down of the information terminal.

### SOLUTION TO PROBLEM

In a first aspect of the present invention, there is provided an information terminal comprising: a front side casing member including a section for clamping on each of two opposite top and bottom sides or on each of two opposite left and right sides of the information terminal when seen from a front side of the terminal. The sections for clamping extend along directions of the opposite sides. The information terminal also comprises a back side casing member including another section for clamping corresponding to the section for clamping of a front side casing member. The back side casing member accommodates an inner structure of the information terminal in conjunction with the front side casing member. The information terminal also comprises a pair of frame members, each frame member holding the section for clamping of the front side casing member and the other section for clamping of the back side casing member together in a clamped state. The information terminal further comprises a first lock mechanism that, after thrusting each frame member onto the section for clamping and the other section for clamping, performs locking when each frame member has been slid in a direction along the opposite sides, and a second lock mechanism that suppresses movement of the frame member following the locking.

### ADVANTAGEOUS EFFECTS OF INVENTION

According to the present invention, such a casing structure may be provided in which the assembling performance as well as the maintenance performance may be optimized and in which there is but little risk of disengagement at the time of falling down.

### BRIEF DESCRIPTION OF THE DRAWINGS

Fig.1 is a perspective view showing an overall appearance of a mobile information terminal according to exemplary embodiment 1 of the present invention.
Fig.2 is an exploded perspective view showing the mobile information terminal according to exemplary embodiment 1 of the present invention, from its front side.
Fig.3 is an exploded perspective view showing the mobile information terminal according to exemplary embodiment 1 of the present invention, from its back side.
Fig.4 is a plan view showing the mobile information terminal according to exemplary embodiment 1 of the present invention.
Fig.5 is a cross-sectional view taken along line A-A of Fig.4.
Fig.6 is a cross-sectional view taken along line B-B of Fig.4.
Fig.7(A), Fig.7(B), Fig.7(C) and Fig.7(D) are schematic views for illustrating the flow of assembling of the mobile information terminal according to the exemplary embodiment 1 of the present invention.
Fig.8 is a perspective view showing a configuration of a mobile information terminal according to exemplary embodiment 2 of the present invention.
Fig.9 is a perspective view showing a configuration of a mobile information terminal according to exemplary embodiment 3 of the present invention.
Fig.10 is a schematic view for illustrating the advantageous effect of the mobile information terminal according to exemplary embodiment 3 of the present invention.
Fig.11 is a perspective view of a mobile information terminal explained as a background art.
Fig.12 is a perspective view showing a back side of the mobile information terminal shown in Fig.9.

### MODES FOR CARRYING OUT THE INVENTION

Initially, an exemplary embodiment of the present invention will be summarized. It is noted that symbols for reference to the drawings are annexed to respective elements simply to assist in the understanding and are not intended to limit the invention to the modes illustrated.

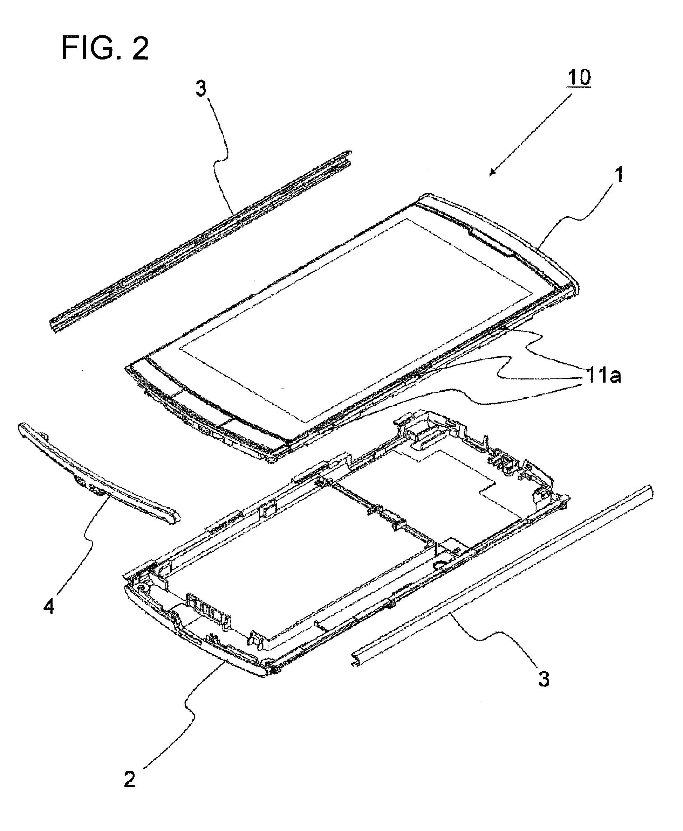

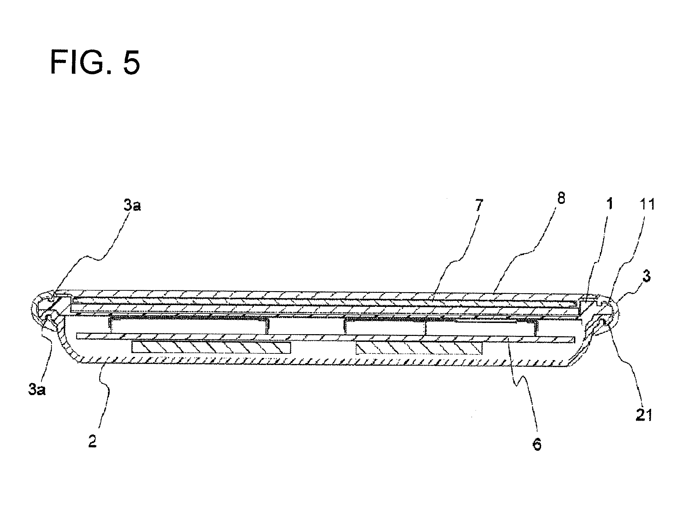

An information terminal according to the present invention comprises a front side casing member (refer to symbol 1 of Fig.5) including a section for clamping (refer to symbol 11 of Fig.5) on each of two opposite top and bottom sides or on each of two opposite left and right sides of the information terminal when seen from a front side of the terminal (refer to side frames 3 of Fig.2). The sections for clamping extend along directions of the two opposite sides. The information terminal also comprises a back side casing member (refer to symbol 2 of Fig.5) including another section for clamping (refer to symbol 21 of Fig.5) corresponding to the section for clamping of the front side casing member. The back side casing member accommodates an inner structure of the information terminal in conjunction with the front side casing member. The information terminal also comprises a pair of frame members (refer to symbol 3 of Fig.5) holding the sections for clamping of the front side casing member and the other sections for clamping of the back side casing member together in a clamped state.

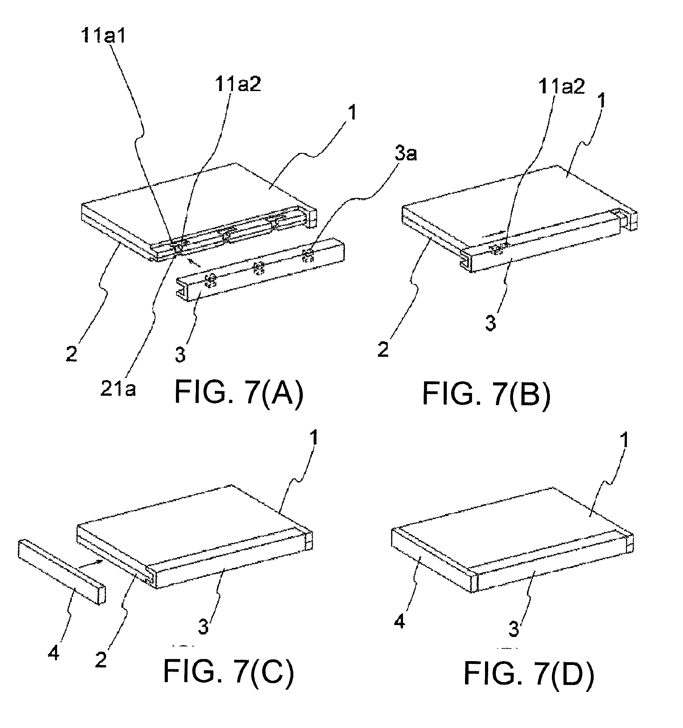

The information terminal also comprises a first lock mechanism (refer to symbols 11a1 , 11a2, 21a, 3a of Fig.7) that, after thrusting the frame member onto the section for clamping and the other section for clamping, performs locking when the frame member has been slid in a direction along the opposite sides. The information terminal further comprises a second lock mechanism (refer to symbol 4 of Fig.7) that suppresses movement of the frame member following the locking.

The information terminal, having the above described configuration, may be assembled or disassembled in accordance with the flow shown in Fig.7. In case of, for example, a falling down, the front side casing member may not be disengaged from the back side casing member unless the second lock mechanism is unlocked.

### [Exemplary embodiment 1]

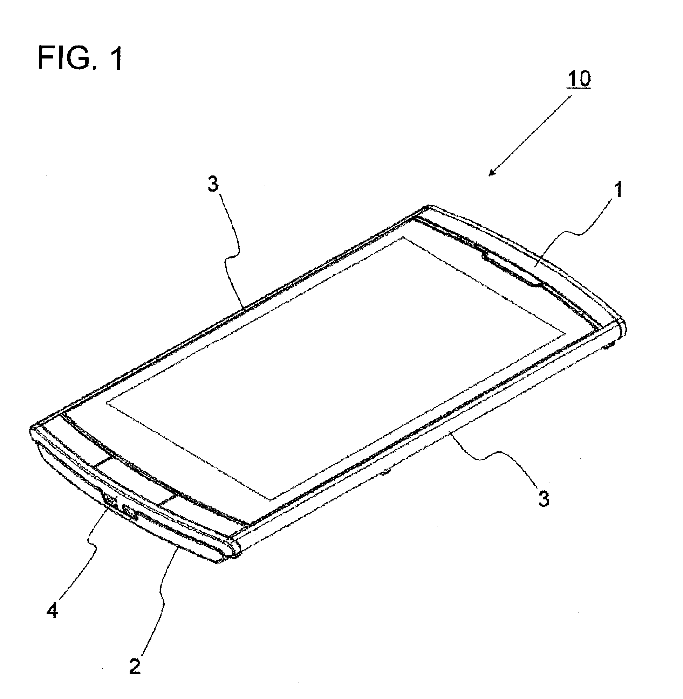

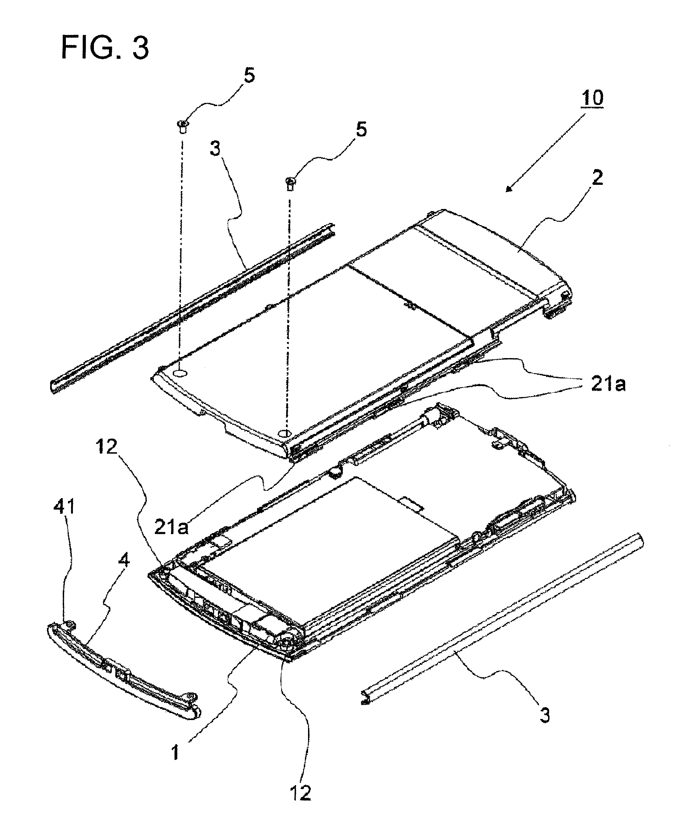

An exemplary embodiment 1, in which the present invention is applied to a smartphone type mobile information terminal, will now be detailed with reference to the drawings. Referring to Fig.1 through to Fig.3, a casing structure of a mobile information terminal 10 may be globally divided into a front side casing member 1, a back side casing member 2, pair side frames 3 and a bottom cover 4. The bottom cover is caused to abut on extreme end parts of the side frames 3 and, in this state, secured in position by a plurality of set screws 5.

The front side casing member 1 is a casing section that covers a front side of the mobile information terminal. The lower end of the front side casing member 1, when seen from the front side of the apparatus, has a screw boss 12 which, in conjunction with the bottom cover 4, may be used to screw the back side casing member 2 in position (see Fig.3).

The back side casing member 2 in conjunction with the front side casing member 1 may be used to define a casing in which to accommodate an inner structure of the mobile information terminal. The lower end of the back side casing member 2, when seen from the front side of the apparatus, includes holes operative in conjunction with registering holes in the bottom cover 4 to screw the back side casing member to the front side casing member 1 (see Fig.3).

Each of the side frames 3 is a metallic bar-shaped member having a semicircular or U-shaped cross-section. By these side frames 3, mounted on both sides of the mobile information terminal 10, it is possible to prevent the casing of the mobile information terminal 10 or a liquid crystal display disposed therein from becoming deformed.

The bottom cover 4 is a cover member on each extreme end of which there is formed a tab 41, as shown in Fig.3. Each tab 41 includes a hole registering with a (threaded hole of) the screw boss of the front side casing member 1 and with a threaded hole of the rear side casing member 2. By screwing the back side casing member 2 to the front side casing member 1, with the bottom cover 4 in contact with extreme end parts of the side frames 3, the bottom cover 4 also may be secured to the front side casing member 1 and to the back side casing member 2.

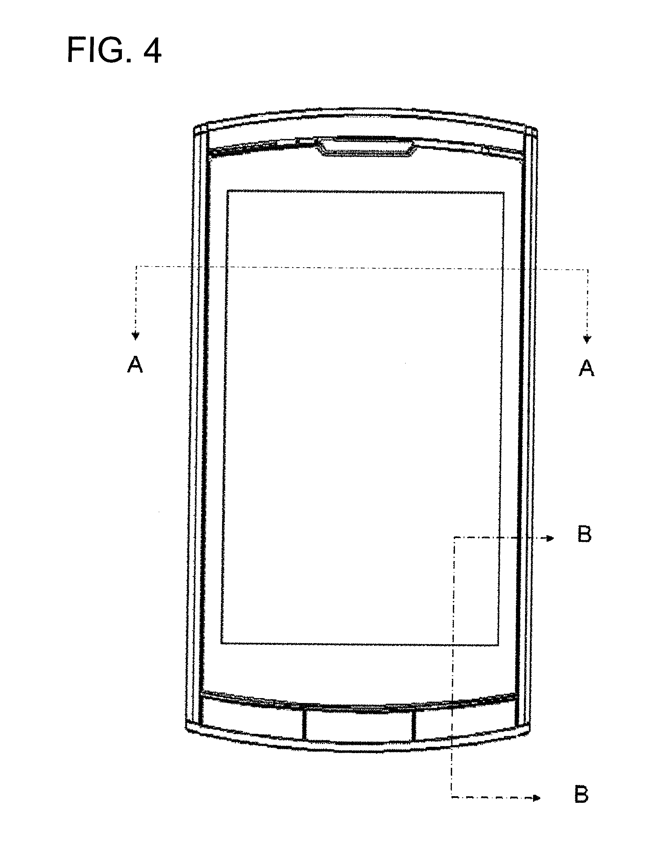

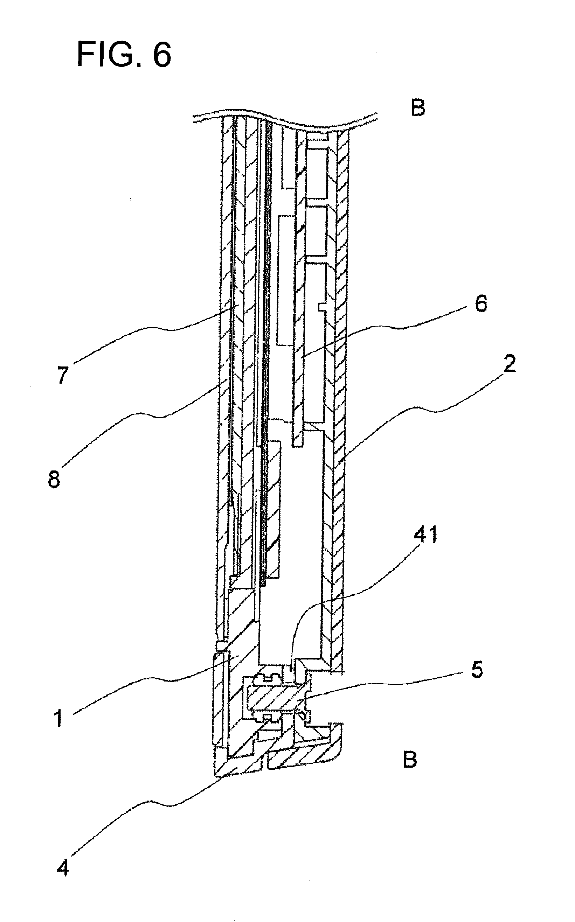

Fig.5 depicts a cross-sectional view taken along line A-A of Fig.4 showing the plan view of the mobile information terminal 10, and Fig.6 depicts a cross-sectional view taken along line B-B of Fig.4 showing the plan view of the mobile information terminal 10. Within the inside of the mobile information terminal 10, delimited by the front side casing member 1 and the back side casing member 2, there are mounted an electrical component 6, such as a board or an IC, and a liquid crystal device (LCD) 7. It is possible to have a variety of the information displayed or to accept a user input using a touch panel over a screen 8.

When seen from the front side of the apparatus, the left and right extreme ends of the front side casing member 1 are each formed as one with a section for clamping 11, whilst the left and right extreme ends of the back side casing member 2 are each formed as one with another section for clamping 21. These sections for clamping are configured to be clamped together by the side frames 3.

Referring to Fig.2, Fig.3 [sic. Fig.5], upper and lower paired protuberances 3a are formed at three sites in an inner surface side of the cross-sectional shape of each of the side frames 3. The sections for clamping 11, 21 are respectively formed as one with three substantially L-shaped grooves 11a, 21a so that these substantially L-shaped grooves are in register each other and with the three paired upper and lower protuberances.

The above mentioned substantially L-shaped grooves 11a, 21a are equivalent to the above mentioned first lock mechanism, and open ends of the grooves 11a, 21a prove push-in sites for the side frames 3. The side frames 3 thus pushed into the open ends of the grooves 11a, 21a are slid along the grooves 11a, 21a as far as their terminal positions to keep the side frames in the state fitted to the front side casing member 1 and to the back side casing member 2.

Fig.7(A), Fig.7(B), Fig.7(C) and Fig.7(D) are perspective views schematically showing the flow of putting the component parts together to form the mobile information terminal according to exemplary embodiment 1 of the present invention. Referring to Fig.7(A), the three substantially L-shaped grooves are formed in each of the front side casing member 1 and the back side casing member 2. In each of the side frames 3, there are formed a sum total of six of the protuberances 3a in register with the substantially L-shaped grooves formed in the front side casing member 1 and the back side casing member 2.

The side frame 3 is pushed as indicated by arrow, at such a position that one of the protuberances 3a is about to be intruded into a first groove section 11a1 of one of the substantially L-shaped grooves extending from an open end of the groove towards the center of the apparatus. By so doing, the side frame 3 is pushed into the inside of the front side casing member 1 and the back side casing member 2, viz., mounted in position, as shown in Fig.7(B).

In this state, the side frame 3 is liable to become detached from the front side casing member 1 and the back side casing member 2. Hence, the side frame 3 is slid in a direction indicated by arrow. The side frame 3 is thus moved along a second groove section 11a2 which is contiguous to the first groove section 11a1 and which extends in the slide direction. In this state, the protuberance 3a of the side frame 3 is caused to abut on a sidewall part of the second groove section 11a2, as shown in Fig.7(C), and hence the side frame 3 may hardly be dismounted from the front side casing member 1 and the back side casing member 2.

If now the side frame 3 is slid in the reverse direction along the second groove section 11a2, reversion is made to the state of Fig.7(B), and hence the side frame 3 is again ready to become detached from the front side casing member 1 and the back side casing member 2. Hence, the bottom cover 4, which suppresses sliding of the side frame 3 in the reverse direction, is mounted in position, so that the state of Fig.7(D) is reached. It is noted that this bottom cover 4 is equivalent to the above mentioned second lock mechanism.

If, with the bottom cover 4 mounted in position, the back side casing member 2 is screwed to the front side casing member 1, the bottom cover 4 and the side frames 3 are in fully secured (fixed) state. In this state, the side frames 3 are not detached, except if the bottom cover 4 is dismounted. Even in case the apparatus is inadvertently dropped, the side frame 3 may not be disengaged except if the total of the sidewall parts of the second groove section 11a2 and the groove 21a on the back side casing member is cracked.

In the present exemplary embodiment, in which the side frames 3 formed of metal of high strength are provided on both lateral sides of the mobile information terminal 10, it is possible to obtain the strength required of the mobile information terminal even though its thickness is reduced.

Moreover, since a metal of weighty appearance is used as a material of the side frames 3, it is possible to get a high quality feeling proper to metal.

In addition, in the present exemplary embodiment, the number of set screws necessary to secure the casing is reduced as compared to the configuration shown in Fig. 12. As a result, the cost may be lowered, while a sufficient space for packaging may be maintained. It is also possible to improve the assembling performance and the maintenance performance as well as to reduce the risk of the set screws for packaging becoming slack. Moreover, it is unnecessary to use a devoted tool to mount/ dismount a clip, such as that shown in Patent Literature 2.

### [Exemplary embodiment 2]

Exemplary embodiment 2 of the present invention will now be detailed with reference to the drawings. In the above described exemplary embodiment 1, the side frame 3 is slid within the substantially L-shaped groove whose extending direction is upward when seen from the front side of the apparatus. In the exemplary embodiment 2, the substantially L-shaped groove is reversed in direction, that is, the extending direction of the substantially L-shaped groove is downward when seen from the front side of the apparatus.

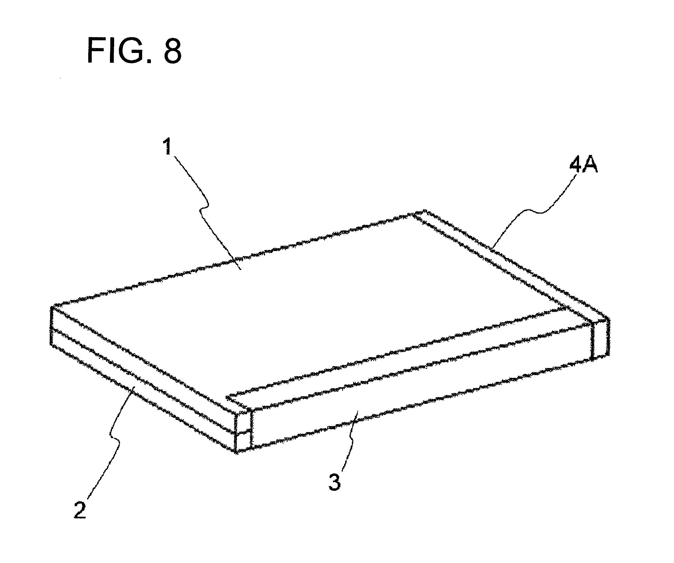

Fig.8 shows an overall appearance of a mobile information terminal according to exemplary embodiment 2 of the present invention. As shown in Fig.8, a top cover 4A is provided as the second lock mechanism in place of the bottom cover, since the extending direction of the substantially L-shaped groove is now reversed. Otherwise, the present exemplary embodiment is the same in the configuration as well as in the packaging method as exemplary embodiment 1 except that the slide direction is reversed. Hence, detailed explanation is dispensed with.

### [Exemplary embodiment 3]

Exemplary embodiment 3 of the present invention will now be detailed with reference to the drawings. In the above described exemplary embodiment 1, the substantially L-shaped groove 21a of the back side casing member 2 is provided on just the reverse side of the substantially L-shaped groove 11a of the front side casing member 1. In the exemplary embodiment 3, the disposition of these substantially L-shaped grooves 11a, 21 a is modified.

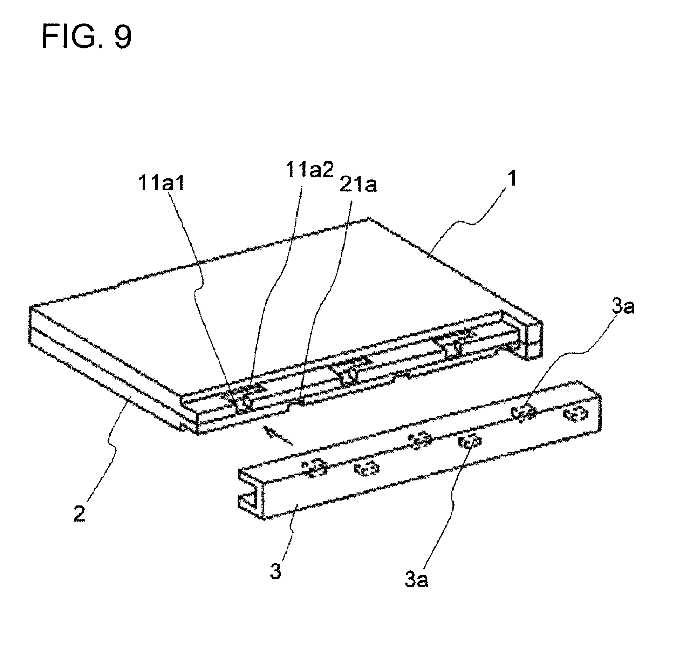

Fig.9 depicts a perspective view showing a configuration of a mobile information terminal according to exemplary embodiment 3 of the present invention. Referring to Fig.9, the substantially L-shaped grooves 11a of the front side casing member 1 are arranged staggered relative to the substantially L-shaped grooves 21a of the back side casing member 2. The protuberances 3a of the side frames 3 are arranged correspondingly.

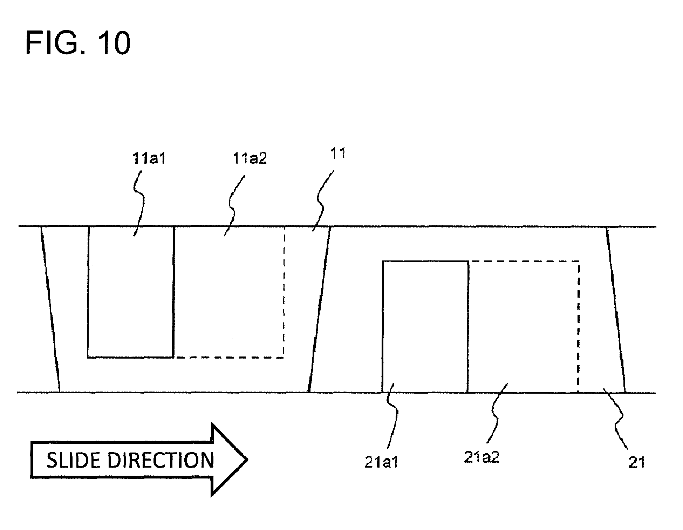

Otherwise, the configuration and the assembling method are the same as those of exemplary embodiment 1, and hence the corresponding explanation is dispensed with. According to the present exemplary embodiment, the substantially L-shaped grooves 11a, 21a may be provided even in case the section for clamping 11 of the front side casing member 1 and the section for clamping 21 of the back side casing member 2 are interlocked in profile with each other as shown in the schematic side view of Fig.10.

Although the description has been made of preferred exemplary embodiments of the present invention, these exemplary embodiments are given only by way of illustration and are not intended to limit the scope of the present invention. That is, further modifications, substitutions or adjustments may be made without departing from the basic technical concept of the invention. For example, in the above described exemplary embodiments, the side frames 3 of metal are used to maintain the strength. However, the side frames may also be formed of resin.

In the above described exemplary embodiments, the bottom cover 4 and the top cover 4A are secured in their positions using set screws 5. Alternatively, the bottom and top covers may also be secured in their positions by engagement of hooks or by fitting elastic components. In this case, no set screws need to be used in the casing structure.

Moreover, in the above described exemplary embodiments, the L-shaped grooves and the protuberances 3a mating therewith are provided at three upper and three lower sites. The number of these L-shaped grooves and the protuberances may, however, be changed in desired manner. The cross-sectional profiles of the side frames 3 may also be other than the semi-circular or U-shaped profile shown in Fig.4 or the channel shape shown inFig.7, provided that the sections for clamping 11, 12 of the front side casing member 1 and the back side casing member 2 can be clamped with the profiles of the side fames used.

In the above described exemplary embodiments, the protuberances 3a are provided on the side frame 3 and the mating grooves are provided in the front side casing member 1 and in the back side casing member 2. It is however possible to provide the grooves in the side frames 3 and to provide the protuberances on the front side casing member 1 and in the back side casing member 2.

In the above described exemplary embodiments, the present invention is applied to a mobile information terminal. Alternatively, the present invention may be applied to a tablet terminal or to a terminal for business use.

The particular exemplary embodiments may be modified or adjusted within the gamut of the entire disclosure of the present invention, inclusive of claims, based on the fundamental technical concept of the invention. Moreover, a variety of combinations or selection of elements disclosed inclusive of the elements of claims, exemplary embodiments and the drawings may be made within the framework of the claims. The present invention may encompass a wide variety of modifications or corrections that may occur to those skilled in the art in accordance with the entire disclosure of the present invention, inclusive of claims and the technical concept of the present invention.

### REFERENCE SIGNS LIST

- 1: front side casing member
- 2: back side casing member
- 3: side frame
- 3a: protuberance
- 4: bottom cover
- 4A: top cover
- 5, 25: set screws
- 6: electrical component
- 7: liquid crystal display device (LCD)
- 8: screen
- 10: mobile information terminal
- 11, 21: sections for clamping
- 11a, 21a: substantially 1-shaped grooves
- 11a1, 21a1: first grooves
- 11a2, 21a2: second grooves
- 12: screw boss
- 41: tab
- 90: information terminal
- 90a: display area
- 91: front side casing
- 92: rear side casing

## Claims

1. An information terminal, comprising:
a front side casing member including a section for clamping on each of two opposite top and bottom sides or on each of two opposite left and right sides of the information terminal when seen from a front side thereof, the sections for clamping extending along directions of the sides;
a back side casing member including another section for clamping corresponding to the section for clamping of a front side casing member, the back side casing member accommodating an inner structure of the information terminal in conjunction with the front side casing member;
a pair of frame members, each frame member holding the section for clamping of the front side casing member and the other section for clamping of the back side casing member together in a clamped state;
a first lock mechanism that, after thrusting each frame member onto the section for clamping and the other section for clamping, performs locking when each frame member has been slid in a direction along the opposite sides; and
a second lock mechanism that suppresses movement of the frame member following the locking.

2. The information terminal according to claim 1, wherein,
the first lock mechanism includes a protuberance formed on an abutting surface of each frame member or on an abutting surface of each of the front side casing member and the back side casing member, a first groove extending along a direction of thrusting the frame member onto the section for clamping and the other section for clamping and defining a push-in position of the frame member in conjunction with the protuberance, and a second groove extending along a direction of the slide in continuation from the first groove to define a locked position of the frame member.

3. The information terminal according to claim 2, wherein,
the first groove and the second groove are respectively provided in the section for clamping of the front side casing member and in the other section for clamping of the back side casing member; and wherein,
a protuberance mating with the first groove and the second groove is formed on an abutting surface of each frame member.

4. The information terminal according to any one of claims 1 to 3, wherein,
the second lock mechanism is a cover member immobilized at the locked position of each frame member in a state the cover member abuts on an extreme end part of each frame member along the slide direction thereof.

5. The information terminal according to claim 4, wherein, the cover member includes a tab that may be intruded into an inside of the front side casing member or the back side casing member; and wherein,
the cover member is secured by screwing a set screw, such that into a threaded hole provided in the front side casing member or in the back side casing member, with the tab introduced into the inside of the front side casing member the set screw is passed through an opening of the tab.
